# FASCICULE DE BREVET EUROPEEN

(11) **EP 2 580 084 B1**
(45) Date de publication et mention de la délivrance du brevet: **02.04.2014**
(21) Numéro de dépôt: 11729130.2
(22) Date de dépôt: 10.06.2011
(51) Int. Cl.: B60K 37/02, B60K 37/04, B29C 41/12, B29C 45/00, B29C 45/14, G06F 3/01, G06F 3/041, G06F 3/0354, B60R 11/02, H03K 17/96, H05K 5/00

(54) **INTERFACE DE COMMANDE POUR VÉHICULE AUTOMOBILE ET PROCÉDÉ DE FABRICATION CORRESPONDANT**
STEUERSCHNITTSTELLE FÜR EIN KRAFTFAHRZEUG UND ZUGEHÖRIGES HERSTELLUNGSVERFAHREN
MOTOR VEHICLE CONTROL INTERFACE AND CORRESPONDING METHOD OF MANUFACTURE

(30) Priorité: 10.06.2010 FR 1002453
(43) Date de publication de la demande: 17.04.2013
(73) Titulaire: Valeo Systemes Thermiques, 78320 Le Mesnil Saint Denis (FR)
(72) Inventeur: GUENIN, Gérard, F-77174 Villeneuve Le Comte (FR)
(74) Mandataire: Pothmann, Karsten
(86) Numéro de dépôt international: PCT/FR2011/000342
(87) Numéro de publication internationale: WO 2011/154626

(56) Documents cités:
- EP-A1- 2 066 162
- EP-A1- 2 154 596
- EP-A1- 2 169 515
- DE-A1-102006 012 147

## Description

La présente invention concerne une interface de commande pour véhicule automobile. Plus précisément, une telle interface trouve une application avantageuse pour les commandes situées à proximité du conducteur, au niveau du panneau de bord ou de la console avant d'un véhicule automobile pour par exemple commander des fonctions de climatisation, d'un système audio, d'un système de téléphonie, d'un système multimédia ou encore d'un système de navigation. L'invention concerne également un procédé de fabrication d'une telle interface de commande.

Une interface de commande par véhicule comprenant les caractéristiques du préambule de la revendication 1 est connue du document EP 2 154 596 A1.

Les dispositifs de commande et d'affichage de véhicule automobile comportent un écran d'affichage pour l'affichage de données d'information ou de commande. Ces écrans peuvent être recouverts d'une dalle tactile transparente permettant la saisie de commandes par les utilisateurs du véhicule. La dalle tactile permet de déterminer les coordonnées de l'appui d'un doigt d'un utilisateur en utilisant par exemple les technologies résistive ou capacitive.

Les dalles tactiles sont des éléments minces et fragiles, laissant apparaître des bords saillants nécessitant d'être protégés et dissimulés. Pour cela, des cadres de protection sont disposés tout autour des dalles tactiles, formant un épaulement en relief. L'écran d'affichage apparaît alors en retrait.

On cherche aujourd'hui à rendre les façades de véhicule plus ergonomiques pour l'utilisateur en proposant des interfaces de commande d'aspect lisse et uniforme au toucher.

L'invention propose une interface de commande améliorée pour véhicule automobile et un procédé de fabrication d'une telle interface permettant d'obtenir une façade d'interface d'aspect lisse et uniforme au toucher.

A cet effet, la présente invention a pour objet une interface de commande pour véhicule automobile comportant :
- une dalle tactile présentant une face avant,
- un boîtier logeant ladite dalle tactile, ledit boîtier présentant une ouverture délimitée par une bordure pour l'accès à la face avant de la dalle tactile par un utilisateur, et
- une garniture de nivellement, périphérique à la dalle tactile, interposée entre une tranche de la dalle tactile et la bordure du boîtier,
caractérisée en ce que ladite interface comporte en outre un joint interposé entre une face arrière de la dalle tactile et une saillie de maintien du boîtier, ledit joint bordant la garniture de nivellement entre la face arrière de la dalle tactile et la saillie de maintien.

Ainsi, on peut utiliser un matériau de garniture liquide introduit à travers le boîtier dans un espace périphérique ménagé entre un moyen de blocage à l'avant, la bordure et la saillie de maintien du boîtier, le joint et la tranche de la dalle tactile. Après polymérisation, le matériau de garniture liquide durcit nivelant ainsi la face avant de la dalle tactile avec les bords du boîtier. Les coulures du matériau de garniture de nivellement sont ainsi stoppées par le joint qui l'empêche de polluer la face arrière de la dalle tactile.

De la sorte, les jeux de montage nécessaires entre le boîtier et la dalle tactile peuvent être normalement prévus sans nuire à l'étanchéité de l'interface. De même, des matériaux de garniture liquide peuvent être choisis parmi les plus fluides afin de mieux combler les interstices existants entre la bordure du boitier et la tranche de la dalle tactile sans risque de fuites au cours du remplissage de l'espace périphérique par le matériau de garniture liquide. Les coulures dans des zones de la dalle tactile pouvant nuire à l'aspect esthétique et fonctionnel de l'interface sont ainsi évitées.

Selon un exemple de réalisation, le joint comporte une mousse. La mousse permet d'exercer une pression modérée sur la dalle tactile, ce qui évite de lui appliquer des contraintes pouvant être interprétées comme des commandes et donc qui nuiraient à son fonctionnement normal. En outre, une fois que le matériau liquide de garniture de nivellement s'est durcit et que la force de maintien appliquée sur le boîtier est relâchée, le joint de mousse n'exerce plus de contrainte sur la dalle tactile, qui présente alors un aspect lisse et uniforme. Le joint conserve cependant une fonction d'étanchéité face à d'éventuels polluants pouvant provenir de la garniture de nivellement, comme du dégazage d'une silicone pouvant altérer la visibilité à travers la dalle tactile. La mousse du joint peut être à alvéoles fermées. Les alvéoles fermées permettent de garantir l'étanchéité vis-à-vis du matériau de garniture. La mousse à alvéoles fermées est par exemple en polyéthylène.

Le joint peut comporter un moyen d'adhésion pour faciliter son positionnement sur la dalle tactile.

La saillie de maintien présente par exemple une forme de cadre s'étendant de la bordure du boîtier vers le centre de l'ouverture.

En outre, la saillie de maintien peut présenter un épaulement intérieur pour assurer la retenue du joint notamment lors de l'application de la force de maintien sur le boîtier.

Au moins un orifice d'injection et au moins un trou d'évent correspondant sont ménagés dans la saillie de maintien respectivement pour l'introduction du matériau liquide de garniture de nivellement et pour l'évacuation d'air. L'air présent dans l'espace périphérique à la dalle tactile est chassé par l'arrivée du matériau liquide de garniture de nivellement et s'échappe par le trou d'évent, ce qui permet de bien répandre le matériau de garniture dans tous les interstices de l'espace périphérique. Le surplus de matière du matériau de garniture peut s'écouler dans les zones voisines de l'orifice d'injection ou du trou d'évent sans déborder sur les surfaces actives de la dalle tactile situées à distance, et donc sans les polluer. Pour une meilleure homogénéité de la garniture de nivellement, l'orifice d'injection et le trou d'évent sont par exemple disposés sur des faces opposées dudit cadre.

Le boîtier peut aussi présenter au moins un moyen de renfort, particulièrement utile lorsque le boîtier est en matériau plastique et que la dalle tactile comporte des plaques de verre. En effet, les coefficients de dilatation thermique étant différents et éloignés, le moyen de renfort permet de renforcer le boîtier pour éviter que, des jeux, jours ou fissures n'apparaissent à la périphérie de la dalle tactile ou pour éviter le cisaillement de la garniture de nivellement.

La présente invention a également pour objet un procédé de fabrication d'une interface de commande telle que précédemment décrite, caractérisé en ce que :
- au cours d'une première étape, on dispose l'ouverture du boîtier autour de la dalle tactile pourvue d'un film en face avant, le film couvrant au moins la face avant de la dalle tactile et les bords du boîtier, un joint étant interposé entre la face arrière de la dalle tactile et une saillie de maintien du boîtier,
- au cours d'une deuxième étape, on applique une force de maintien sur le boîtier pour le maintenir et pour écraser le joint entre la face arrière de la dalle tactile et la saillie de maintien du boîtier, et
- au cours d'une troisième étape, on introduit le matériau liquide de garniture de nivellement par l'orifice d'injection débouchant de la saillie de maintien dans un espace périphérique cloisonné par le film, la bordure et la saillie de maintien du boîtier, le joint et la tranche de la dalle tactile, pour répandre le matériau liquide de garniture de nivellement dans ledit espace périphérique.

Le film, nécessaire pour protéger et/ou décorer la façade, fait barrière à la garniture de nivellement, formant un moyen de blocage à l'avant, évitant ainsi d'avoir à utiliser un moule qui aurait nécessité plusieurs étapes supplémentaires au cours de la fabrication, dont une étape de nettoyage de la garniture de nivellement via des agents de démoulage et une étape de laminage pour dérouler et plaquer le film postérieurement sur la façade de l'interface. De même, le joint fait office de butée interne pour la garniture de nivellement et évite notamment des étapes ultérieures de nettoyage à l'intérieur du boîtier. Ainsi, le procédé est simple car il ne nécessite qu'une seule opération d'introduction du matériau de garniture liquide. Sa qualité est accrue vis-à-vis des procédés de fabrication antérieurs car ce procédé limite les risques de bavure sur les surfaces de la dalle tactile. En outre, on est assuré d'obtenir une surface lisse en façade de l'interface lorsqu'on enlève la force de maintien exercée sur le joint.

La présente invention a encore pour objet un procédé de fabrication d'une interface de commande telle que précédemment décrite, caractérisé en ce que :
- au cours d'une première étape, on dispose la dalle tactile et le boîtier sur une surface préconformée, l'ouverture du boîtier entourant la face avant de la dalle tactile, ladite ouverture et ladite face avant étant disposées face à la surface préconformée, un joint étant interposé entre la face arrière de la dalle tactile et une saillie de maintien du boîtier,
- au cours d'une deuxième étape, on applique une force de maitien sur le boîtier pour le maintenir face à la surface préconformée et pour écraser le joint entre la face arrière de la dalle tactile et la saillie de maintien, et
- au cours d'une troisième étape, on introduit le matériau liquide de garniture de nivellement par l'orifice d'injection débouchant de la saillie de maintien dans un espace périphérique cloisonné par la surface préconformée, la bordure et la saillie de maintien du boîtier, le joint et la tranche de la dalle tactile, pour répandre le matériau liquide de garniture de nivellement dans ledit espace périphérique, et
- au cours d'une quatrième étape, on dépose un film couvrant au moins la face avant de la dalle tactile, la garniture de nivellement et les bords du boîtier.

Par exemple, au cours de la deuxième étape, on écrase le joint avec un taux de compression compris entre 5% et 40%. Ainsi, avec un taux au minimum de 5%, on s'assure que le joint est comprimé un minimum pour assurer une bonne étanchéité et avec un taux au maximum de 40%, on évite d'appliquer des efforts trop importants sur le film qui pourraient le déformer.

D'autres caractéristiques et avantages de l'invention ressortiront de la description suivante, donnée à titre d'exemple, sans caractère limitatif, en regard des dessins annexés sur lesquels :
- la figure 1 représente une vue schématique arrière d'une interface de commande sur laquelle des éléments de l'interface apparaissent en pointillés,
- la figure 2a représente une vue en coupe de côté d'une dalle tactile pourvue d'un film et d'un joint, d'une interface de commande similaire à celle de la figure 1,
- la figure 2b représente une vue similaire à la figure 2a au cours d'une deuxième étape d'un premier mode de réalisation d'un procédé de fabrication d'une interface de commande,
- la figure 2c représente une vue similaire à la figure 2a au cours d'une troisième étape dudit procédé de fabrication,
- la figure 3a représente une vue en coupe de côté d'une dalle tactile pourvue d'un joint, d'une interface similaire à celle de la figure 1, posée sur une surface préconformée plane,
- la figure 3b représente une vue similaire à la figure 3a au cours d'une deuxième étape d'un deuxième mode de réalisation d'un procédé de fabrication de l'interface de commande,
- la figure 3c représente une vue similaire à la figure 3a au cours d'une troisième étape dudit procédé de fabrication, et
- la figure 3d représente une vue similaire à la figure 3a au cours d'une quatrième étape dudit procédé de fabrication.
Sur ces figures, les éléments identiques portent les mêmes numéros de référence.

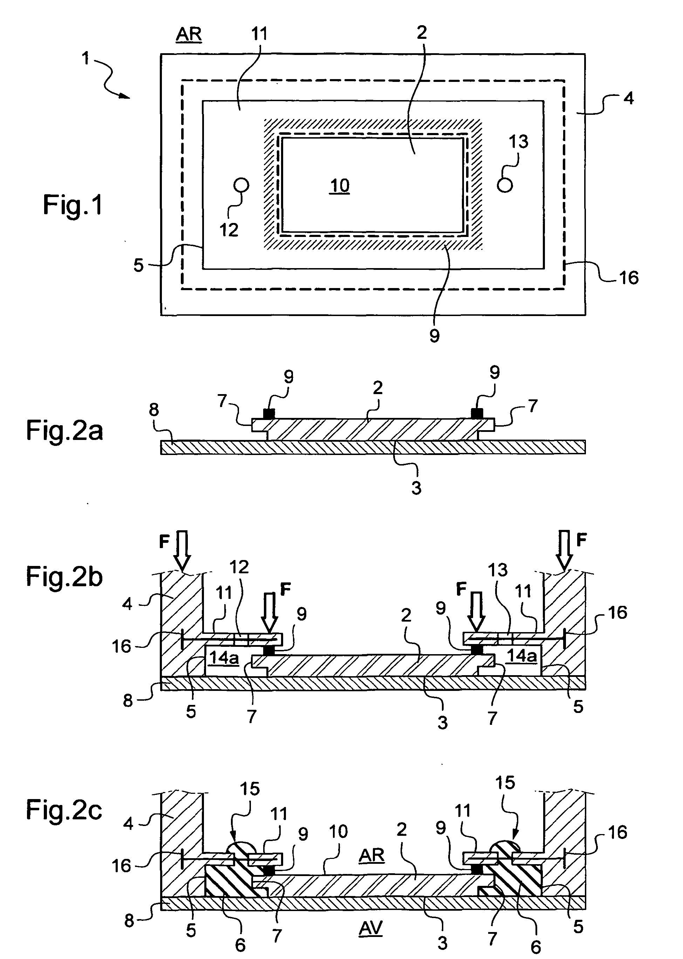

La figure 1 représente une vue schématique arrière d'une interface de commande 1 pour véhicule automobile. L'interface 1 peut être fixée à proximité de l'utilisateur, par exemple au niveau d'une console centrale du véhicule ou au niveau du panneau de bord (non représenté) pour par exemple commander des fonctions de climatisation, d'un système audio, d'un système de téléphonie, d'un système multimédia ou encore d'un système de navigation.

L'interface 1 comporte une dalle tactile 2 présentant une face avant 3 (voir figure 2b), c'est à dire orientée vers l'utilisateur pour la saisie de commandes, un boîtier 4 logeant la dalle tactile 2, ledit boîtier 4 présentant une ouverture délimitée par une bordure 5 au moins au droit de la face avant 3 de la dalle tactile pour permettre son accès à un utilisateur, et une garniture de nivellement 6 (voir figure 2c), interposée entre la tranche 7 de la dalle tactile 2 et la bordure 5 du boîtier 4.

L'interface 1 comporte également un écran d'affichage (non représenté), pour l'affichage de données d'information ou de commande, tel qu'un écran TFT (utilisant la technologie des couches minces de transistor ou « Thin film transistor » en anglais).

La dalle tactile 2 est superposée sur l'écran et comporte un capteur résistif ou un capteur capacitif, l'un ou l'autre étant au moins partiellement transparent, pour la saisie de commandes par un utilisateur. Dans le cas d'un capteur résistif, ce dernier comporte une plaque principale et d'une plaque secondaire. Ces deux plaques sont en verre, la plaque secondaire étant plus fine que la plaque principale. La plaque secondaire présente la fonction de se déformer sous une force d'appui exercée par le doigt de l'utilisateur alors que la plaque principale est moins déformable, son épaisseur est telle qu'elle ne fléchit pas sous l'effet d'une pression exercée par le doigt d'un utilisateur. Le capteur est ainsi en mesure de détecter la position du doigt de l'utilisateur grâce à un réseau de conducteurs placé entre la plaque principale et la plaque secondaire, selon une disposition par exemple horizontale et verticale. La dalle tactile 2 est reliée électriquement à une carte électronique au moyen d'un flexible multiconducteur, la carte électronique assurant l'interprétation de la détection effectuée par la dalle tactile 2.

Visible sur la figure 2c, la garniture de nivellement 6 est périphérique à la tranche 7 de la dalle tactile 2, pour niveler la face avant 3 de la dalle tactile 2 avec les bords du boîtier 4. Ainsi, la garniture de nivellement 6 met à niveau la dalle tactile 2 avec le boîtier 4 de sorte que l'utilisateur ne perçoive qu'une surface lisse et uniforme au toucher, sans aspérités ou renflements, le glissement du doigt sur la frontière entre la dalle tactile 2 et le boîtier 4 n'étant pas perceptible et pouvant en outre être rendu invisible par le choix du coloris utilisé, donnant l'impression d'une surface continue.

L'interface 1 comporte en outre un joint 9 (figure 2b), interposé entre une face arrière 10 de la dalle tactile 2 et une saillie de maintien 11 du boîtier 4, le joint 9 bordant la garniture de nivellement 6 entre la face arrière 10 de la dalle tactile 2 et la saillie de maintien 11. Ainsi, on peut utiliser un matériau de garniture liquide pour l'introduire à travers le boîtier 4 dans un espace périphérique 14a ménagé entre un moyen de blocage à l'avant, la bordure 5 et la saillie de maintien 11 du boîtier 4, le joint 9 et la tranche 7 de la dalle tactile 2. Après polymérisation, le matériau de garniture liquide durcit nivelant ainsi la face avant de la dalle tactile 2 avec les bords du boîtier 4. Les coulures du matériau de garniture de nivellement 6 sont ainsi stoppées par le joint 9 qui l'empêche de polluer la face arrière 10 de la dalle tactile 2.

De la sorte, les jeux de montage nécessaires entre le boîtier 4 et la dalle tactile 2 peuvent être normalement prévus sans nuire à l'étanchéité de l'interface 1. De même, des matériaux de garniture liquide peuvent être choisis parmi les plus fluides afin de mieux combler les interstices existants entre la bordure du boitier 4 et la tranche 7 de la dalle tactile 2 sans risque de fuites au cours du remplissage de l'espace périphérique 14a par le matériau liquide de garniture de nivellement 6. Les coulures dans des zones de la dalle tactile pouvant nuire à l'aspect esthétique et fonctionnel de l'interface sont ainsi évitées.

L'interface 1 comporte également un film 8 sur sa façade avant. Le film 8 couvre la face avant 3 de la dalle tactile 2 accessible à l'utilisateur (ou surface de commande), la garniture de nivellement 6 et les bords du boîtier 4, les dimensions du film 8 et les dimensions de l'interface 1 étant similaires, voire identiques.

Le film 8, nécessaire pour protéger et/ou décorer la façade présente une ou plusieurs des caractéristiques parmi lesquelles : des décors, des propriétés anti-rayure, des propriétés antireflets et diffusantes, ces dernières donnant un aspect mat à l'interface et évitant les effets miroirs gênants pour l'utilisateur, la propriété antireflet empêchant que la lumière incidente ne ressorte de la surface, des propriétés de diffusion éclatant la lumière incidente en la renvoyant dans toutes les directions, et/ou des propriétés polarisantes, c'est-à-dire susceptibles de barrer la lumière réfléchie par les plaques de verre de la dalle tactile dans une direction donnée.

Outre sa fonction de combler les écarts de plan de la façade avant de l'interface 1, la garniture de nivellement 6 adhère au film 8 pour leurs surfaces communes. La garniture de nivellement 6 maintient également la dalle tactile 2 avec le boîtier 4 tout en conservant une certaine souplesse pour l'absorption d'éventuelles contraintes sur le boîtier 4 et protège et guide le flexible multiconducteur en partie noyé dans la garniture de nivellement 6 des vibrations du véhicule automobile ou des arêtes vives de la dalle tactile 2.

On choisit pour cela un matériau pouvant être injecté/coulé à basse pression et à faible température comme un élastomère, tel qu'un matériau EPDM (Éthylène Propylène Diène Monomère), un TPE (élastomère thermoplastique tel qu'un matériau SEBS (Styrène-éthylène-butylène-styrène), SBS (styrène-butadiène-styrène) ou TPU (Polyuréthane thermoplastique)) ou un élastomère silicone. On peut également orienter le choix de la garniture de nivellement 6 sur un matériau présentant une meilleure fluidité pour mieux combler les interstices, présentant en outre des propriétés adhésives et de souplesse, comme une silicone ou une colle durcissant après exposition aux rayonnements ultraviolets (ou colle UV) ou une colle polyuréthane. Lorsque le matériau de garniture de nivellement est polymérisé ou réticulé, par chauffage ou après un temps de séchage (silicone), ou par exposition au rayonnement ultraviolet (colle UV), ces matériaux se rigidifient, permettant un aspect lisse au toucher.

Le joint 9 comporte par exemple une mousse. La mousse 9 permet d'exercer une pression modérée sur la dalle tactile 2, évitant de lui appliquer des contraintes pouvant être interprétées comme des commandes qui pourraient nuire à son fonctionnement normal. En outre, une fois que le matériau liquide de garniture de nivellement 6 s'est durcit et que la force de maintien appliquée sur le boîtier 4 est relâchée, le joint de mousse 9 n'applique plus de contrainte sur la dalle tactile 2, qui présente alors un aspect lisse et uniforme. Le joint 9 conserve cependant une fonction d'étanchéité face à d'éventuels polluants pouvant provenir de la garniture de nivellement 6, comme du dégazage d'une silicone pouvant altérer la visibilité à travers la dalle tactile 2.

La mousse du joint 9 est à alvéoles fermées. Les alvéoles fermées permettent de garantir l'étanchéité vis-à-vis du matériau de garniture. La mousse à alvéoles fermées est par exemple en polyéthylène. La mousse du joint 9 peut aussi être en silicone ou en caoutchouc.

Selon un autre exemple, le joint 9 est moulé ou à lèvres (non représenté).

Le joint 9 peut comporter un moyen d'adhésion pour faciliter son positionnement sur la dalle tactile 2. Par exemple, le joint 9 est fixé à la dalle tactile 2 par un adhésif double face.

La saillie de maintien 11 présente une forme de cadre s'étendant de la bordure 5 du boîtier 4 vers le centre de l'ouverture. On peut aussi prévoir que la saillie de maintien 11 soit repliée à son extrémité libre pour former un épaulement intérieur et ainsi assurer la retenue du joint 9 notamment lors de l'application de la force de maintien F sur le boîtier 4 (non représenté).

Au moins un orifice d'injection 12 et au moins un trou d'évent 13 correspondant (figure 1 et 2b) sont ménagés dans la saillie de maintien 11 respectivement pour l'introduction du matériau liquide de garniture de nivellement 6 et pour l'évacuation d'air. L'air présent dans l'espace périphérique 14a à la dalle tactile 2 est chassé par l'arrivée du matériau liquide de garniture de nivellement 6 et s'échappe par le trou d'évent 13, ce qui permet de bien répandre le matériau de garniture dans tous les interstices de l'espace périphérique 14a. Le surplus de matière du matériau de garniture peut s'écouler dans les zones 15 voisines de l'orifice d'injection 12 ou du trou d'évent 13 sans déborder sur les surfaces actives de la dalle tactile 2 situées à distance, et donc sans les polluer.

Pour une meilleure homogénéité de la garniture de nivellement 6, l'orifice d'injection 12 et le trou d'évent 13 peuvent être disposés sur des faces opposées du cadre.

Le boîtier 4 de l'interface 1 peut comporter au moins un moyen de renfort 16. Le moyen de renfort 16 est particulièrement utile lorsque le boîtier 4 est en matériau plastique et que la dalle tactile 2 comporte des plaques de verre. En effet, les coefficients de dilatation thermique étant différents et éloignés, le moyen de renfort 16 permet de renforcer le boîtier 4 pour éviter que, des jeux, jours ou fissures n'apparaissent à la périphérie de la dalle tactile 2 ou pour éviter le cisaillement de la garniture de nivellement 6. Le moyen de renfort 16 est un élément structurel faisant partie ou étant intégré au boîtier 4. Le moyen de renfort présente par exemple une forme de cadre, inséré dans la saillie de maintien 11 du boîtier 4. Il peut être surmoulé ou entièrement noyé dans le boîtier 4. Le moyen de renfort 16 est susceptible de renforcer la tenue mécanique du boîtier 4 pour que ce dernier se dilate de la même manière que la dalle tactile 2, lorsqu'ils sont soumis à de grandes amplitudes thermiques. Par exemple, le moyen de renfort 16 est métallique, tel qu'en acier, ce qui confère au boîtier 4 la résistance mécanique nécessaire pour résister aux contraintes thermiques et mécaniques présentes dans un habitacle de véhicule automobile (entre -40°C et + 105°C).

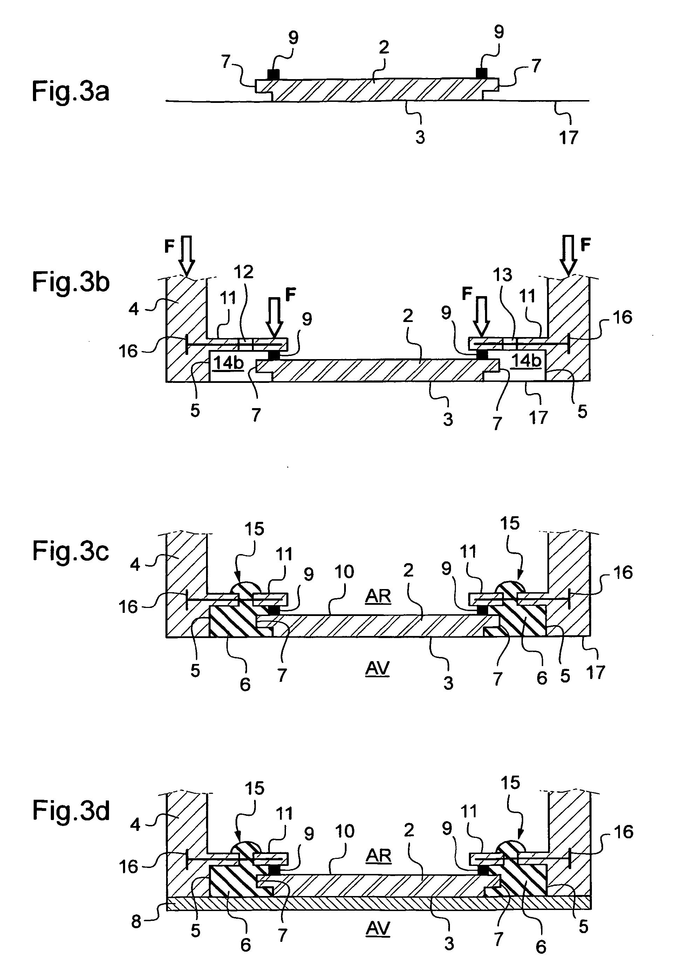

On va maintenant décrire plus en détails deux modes de réalisation du procédé de fabrication, le premier mode de réalisation étant illustré par les figures 2a, 2b et 2c et le deuxième mode de réalisation étant illustré par les figures 3a, 3b, 3c et 3d.

Dans le premier mode de réalisation, la face avant 3 de la dalle tactile 2 est préalablement pourvue d'un film 8, par exemple, préencollé, et débordant de part et d'autre de ladite face avant 3. Un joint 9 est disposé, par exemple par adhérence, sur la face arrière 10 de la dalle tactile 2 (figure 2a).

Au cours d'une première étape, on place le boîtier 4 autour de la dalle tactile 2, l'ouverture du boîtier 4 étant centrée sur la dalle tactile 2, le film 8 couvrant ainsi au moins la face avant 3 de la dalle tactile 2 et les bords du boîtier 4, le joint étant interposé entre la face arrière 10 de la dalle tactile 2 et une saillie de maintien 11 du boîtier 4 (figure 2b).

Au cours d'une deuxième étape, on applique une force de maintien F (voir flèches sur la figure 2b) sur le boîtier 4 pour le maintenir et pour écraser le joint 9 entre la face arrière 10 de la dalle tactile 2 et la saillie de maintien 11. La force de maintien F est appliquée par un outillage adapté pour appliquer une légère pression. Par exemple, on écrase le joint 9 avec un taux de compression compris entre 5% et 40%. Ainsi, avec un taux au minimum de 5%, on s'assure que le joint est comprimé un minimum pour assurer une bonne étanchéité et avec un taux au maximum de 40%, on évite d'appliquer des efforts trop importants sur le film qui pourraient le déformer.

Au cours d'une troisième étape, on introduit le matériau liquide de garniture de nivellement 6 par l'orifice d'injection 12 débouchant de la saillie de maintien 11 dans un espace périphérique 14a cloisonné par le film 8, la bordure 5 et la saillie de maintien 11 du boîtier 4, le joint 9 et la tranche 7 de la dalle tactile 2, pour répandre le matériau de garniture dans ledit espace périphérique 14a. Le film 8 fait alors office de butée frontale pour le matériau de garniture de nivellement 6. Le matériau liquide de garniture de nivellement 6 est introduit par coulage par gravité ou par injection. L'injection est réalisée à basse pression (<5bars) et facilite l'écoulement du matériau liquide de garniture de nivellement dans l'espace périphérique à remplir de l'ordre de quelques dixièmes.

Après polymérisation, le matériau liquide de garniture de nivellement 6 durcit. On peut accélérer la polymérisation par chauffage ou exposition au rayonnement ultraviolet selon le type de matériau choisi pour la garniture de nivellement 6.

Le film 8 fait barrière à la garniture de nivellement 6, formant un moyen de blocage à l'avant, évitant ainsi d'avoir à utiliser un moule qui aurait nécessité plusieurs étapes supplémentaires au cours de la fabrication, dont une étape de nettoyage de la garniture de nivellement via des agents de démoulage et une étape de laminage pour dérouler et plaquer le film 8 postérieurement sur la façade de l'interface 1. De même, le joint 9 fait office de butée interne pour la garniture de nivellement 6 et évite notamment des étapes ultérieures de nettoyage à l'intérieur du boîtier. Ainsi, le procédé est simple car il ne nécessite qu'une seule opération d'introduction du matériau liquide de garniture de nivellement 6. Sa qualité est accrue vis-à-vis des procédés de fabrication antérieurs car ce procédé limite les risques de bavure sur les surfaces de la dalle tactile 2. En outre, on est assuré d'obtenir une surface lisse en façade de l'interface lorsqu'on enlève la force de maintien F exercée sur le joint 9.

Les figures 3a, 3b, 3c et 3d, illustrent le deuxième mode de réalisation du procédé de fabrication de l'interface 1 (seuls les éléments différents du premier mode de réalisation sont décrits). Le procédé de fabrication de l'interface se différencie principalement du premier mode de réalisation par les étapes décrites ci-après.

Au cours d'une première étape (figure 3a et 3b) on dispose la dalle tactile 2 et le boîtier 4 sur une surface préconformée 17, par exemple plane pour une dalle tactile 2 en verre, l'ouverture du boîtier 4 entourant la face avant 3 de la dalle tactile 2, l'ouverture et la face avant 3 étant disposées face à la surface préconformée 17, le joint 9 étant interposé entre la face arrière 10 de la dalle tactile 2 et une saillie de maintien 11 du boîtier 4.

Au cours d'une deuxième étape (figure 3b), on applique une force F sur le boîtier 4 pour le maintenir face à la surface préconformée 17et pour écraser le joint 9, via la saillie de maintien 11 du boîtier 4.

Au cours d'une troisième étape (figure 3c), on introduit le matériau liquide de garniture de nivellement par l'orifice d'injection 12 débouchant de la saillie de maintien 11 dans un espace périphérique 14b cloisonné par la surface préconformée 17, la bordure 5 et la saillie de maintien 11 du boîtier 4, le joint 9 et la tranche 7 de la dalle tactile 2, pour répandre le matériau de garniture 6 dans ledit espace périphérique 14b. La surface préconformée 17 forme un moyen de blocage à l'avant pour le matériau liquide de garniture de nivellement 6.

Au cours d'une quatrième étape (figure 3d), on dépose par laminage (étirage et plaquage) le film 8 sur la façade avant de l'interface 1, en couvrant la face avant 3 de la dalle tactile 2, la garniture de nivellement 6 et les bords du boîtier 4, après nettoyage et éventuellement ébavurage de ladite façade avant.

## Revendications

1. Interface de commande pour véhicule automobile comportant :
- une dalle tactile (2) présentant une face avant (3),
- un boîtier (4) logeant ladite dalle tactile (2), ledit boîtier (4) présentant une ouverture délimitée par une bordure (5) pour l'accès à la face avant (3) de la dalle tactile (2) par un utilisateur, et
- une garniture de nivellement (6), périphérique à la dalle tactile (2), interposée entre une tranche (7) de la dalle tactile (2) et la bordure (5) du boîtier (4),
**caractérisée en ce que** ladite interface comporte en outre un joint (9) interposé entre une face arrière (10) de la dalle tactile (2) et une saillie de maintien (11) du boîtier (4), ledit joint (9) bordant la garniture de nivellement (6) entre la face arrière (10) de la dalle tactile (2) et la saillie de maintien (11).

2. Interface selon la revendication 1, **caractérisée en ce que** ledit joint (9) comporte une mousse.

3. Interface selon la revendication 2, **caractérisée en ce que** ledit joint (9) comporte une mousse à alvéoles fermées.

4. Interface selon la revendication 3, **caractérisée en ce que** ladite mousse à alvéoles fermées est en polyéthylène.

5. Interface selon l'une des revendications 1 à 4, **caractérisée en ce que** ledit joint (9) comporte un moyen d'adhésion.

6. Interface selon l'une des revendications 1 à 5, **caractérisée en ce que** la saillie de maintien (11) présente une forme de cadre s'étendant de la bordure (5) du boîtier (4) vers le centre de l'ouverture.

7. Interface selon l'une des revendications 1 à 6, **caractérisée en ce que** la saillie de maintien présente un épaulement intérieur.

8. Interface selon l'une des revendications 1 à 7, **caractérisée en ce qu'**au moins un orifice d'injection (12) et au moins un trou d'évent (13) correspondant sont ménagés dans la saillie de maintien (11) respectivement pour l'introduction du matériau liquide de garniture de nivellement (6) et pour l'évacuation d'air.

9. Interface selon la revendication 8, prise ensemble avec la revendication 7, **caractérisée en ce que** ledit orifice d'injection (12) et ledit trou d'évent (13) sont disposés sur des faces opposées dudit cadre.

10. Interface selon l'une des revendications précédentes, **caractérisée en ce que** le boîtier (4) présente au moins un moyen de renfort (16).

11. Procédé de fabrication d'une interface de commande selon l'une des revendications 1 à 10, **caractérisé en ce que** :
- au cours d'une première étape, on dispose l'ouverture du boîtier (4) autour de la dalle tactile (2) pourvue d'un film (8) en face avant (3), le film (8) couvrant au moins la face avant (3) de la dalle tactile et les bords du boîtier, un joint (9) étant interposé entre la face arrière (10) de la dalle tactile et une saillie de maintien (11) du boîtier,
- au cours d'une deuxième étape, on applique une force de maintien (F) sur le boîtier pour le maintenir et pour écraser le joint (9) entre la face arrière de la dalle tactile et la saillie de maintien du boîtier, et
- au cours d'une troisième étape, on introduit un matériau liquide de garniture de nivellement (6) par l'orifice d'injection (12) débouchant de la saillie de maintien (11) dans un espace périphérique (14a) cloisonné par le film (8), la bordure (5) et la saillie de maintien (11) du boîtier, le joint (9) et la tranche (7) de la dalle tactile, pour répandre le matériau liquide de garniture de nivellement (6) dans ledit espace périphérique (14a).

12. Procédé de fabrication d'une interface de commande selon l'une des revendications 1 à 10, **caractérisé en ce que** :
- au cours d'une première étape, on dispose la dalle tactile (2) et le boîtier (4) sur une surface préconformée (17), l'ouverture du boîtier entourant la face avant (3) de la dalle tactile, ladite ouverture et ladite face avant étant disposées face à la surface préconformée (17), un joint (9) étant interposé entre la face arrière (10) de la dalle tactile et une saillie de maintien (11) du boîtier,
- au cours d'une deuxième étape, on applique une force de maintien (F) sur le boîtier pour le maintenir face à la surface préconformée (17) et pour écraser le joint (9) entre la face arrière (10) de la dalle tactile et la saillie de maintien (11), et
- au cours d'une troisième étape, on introduit le matériau liquide de garniture de nivellement (6) par l'orifice d'injection (12) débouchant de la saillie de maintien (11) dans un espace périphérique (14b) cloisonné par la surface préconformée (17), la bordure (5) et la saillie de maintien (11) du boîtier, le joint (9) et la tranche (7) de la dalle tactile, pour répandre le matériau liquide de garniture de nivellement (6) dans ledit espace périphérique (14b), et
- au cours d'une quatrième étape, on dépose un film (8) couvrant au moins la face avant (3) de la dalle tactile, la garniture de nivellement (6) et les bords du boîtier (4).

13. Procédé de fabrication selon l'une des revendications 11 ou 12, **caractérisé en ce qu'**au cours de la deuxième étape, on écrase le joint (9) avec un taux de compression compris entre 5% et 40%.

## Patentansprüche

1. Steuerschnittstelle für Kraftfahrzeug, die Folgendes umfasst:
- eine taktile Platte (2), die eine Vorderseite (3) aufweist,
- ein Gehäuse (4), das die taktile Platte (2) aufnimmt, wobei das Gehäuse (4) eine durch einen Rand (5) begrenzte Öffnung für den Zugang zu der Vorderseite (3) der taktilen Platte (2) durch einen Anwender aufweist, und
- eine Höhenausgleichsverkleidung (6) am Umfang der taktilen Platte (2), die zwischen eine Schnittfläche (7) der taktilen Platte (2) und den Rand (5) des Gehäuses (4) eingefügt ist,
**dadurch gekennzeichnet, dass** die Schnittstelle außerdem eine Dichtung (9) umfasst, die zwischen eine Rückseite (10) der taktilen Platte (2) und einen Haltevorsprung (11) des Gehäuses (4) eingefügt ist, wobei die Dichtung (9) an die Höhenausgleichsverkleidung (6) zwischen der Rückseite (10) der taktilen Platte (2) und dem Haltevorsprung (11) angrenzt.

2. Schnittstelle nach Anspruch 1, **dadurch gekennzeichnet, dass** die Dichtung (9) einen Schaumstoff enthält.

3. Schnittstelle nach Anspruch 2, **dadurch gekennzeichnet, dass** die Dichtung (9) einen Schaumstoff mit geschlossenen Poren enthält.

4. Schnittstelle nach Anspruch 3, **dadurch gekennzeichnet, dass** der Schaumstoff mit geschlossenen Poren Polyethylen enthält.

5. Schnittstelle nach einem der Ansprüche 1 bis 4, **dadurch gekennzeichnet, dass** die Dichtung (9) ein Haftmittel enthält.

6. Schnittstelle nach einem der Ansprüche 1 bis 5, **dadurch gekennzeichnet, dass** der Haltevorsprung (11) die Form eines Rahmens aufweist, der sich von dem Rand (5) des Gehäuses (4) in die Mitte der Öffnung erstreckt.

7. Schnittstelle nach einem der Ansprüche 1 bis 6, **dadurch gekennzeichnet, dass** der Haltevorsprung eine Innenschulter aufweist.

8. Schnittstelle nach einem der Ansprüche 1 bis 7, **dadurch gekennzeichnet, dass** wenigstens eine Einspritzöffnung (12) und wenigstens ein entsprechendes Entlüftungsloch (13) in dem Haltevorsprung (11) ausgebildet sind, um das flüssige Höhenausgleichsverkleidungsmaterial (6) einzuleiten bzw. um die Luft abzuführen.

9. Schnittstelle nach Anspruch 8, wenn abhängig von Anspruch 7, **dadurch gekennzeichnet, dass** die Einspritzöffnung (12) und das Lüftungsloch (13) auf gegenüberliegenden Seiten des Rahmens angeordnet sind.

10. Schnittstelle nach einem der vorhergehenden Ansprüche, **dadurch gekennzeichnet, dass** das Gehäuse (4) wenigstens ein Verstärkungsmittel (16) aufweist.

11. Verfahren für die Herstellung einer Steuerschnittstelle nach einem der Ansprüche 1 bis 10, **dadurch gekennzeichnet, dass**:
- während eines ersten Schrittes die Öffnung des Gehäuses (4) um die mit einem Film (8) auf der Vorderseite (3) versehene taktile Platte (2) angeordnet wird, wobei der Film (8) wenigstens die Vorderseite (3) der taktilen Platte und die Ränder des Gehäuses abdeckt, wobei zwischen die Rückseite (10) der taktilen Platte und einen Haltevorsprung (11) des Gehäuses eine Dichtung (9) eingefügt ist,
- während eines zweiten Schrittes eine Haltekraft (F) auf das Gehäuse ausgeübt wird, um es zu halten und um die Dichtung (9) zwischen der Rückseite der taktilen Platte und dem Haltevorsprung des Gehäuses einzuklemmen, und
- während eines dritten Schrittes ein flüssiges Höhenausgleichsverkleidungsmaterial (6) durch die Einspritzöffnung (12), die aus dem Haltevorsprung (11) in einen durch den Film (8), den Rand (5) und den Haltevorsprung (11) des Gehäuses, die Dichtung (9) und die Schnittfläche (7) der taktilen Platte abgeteilten Umfangsraum (14a) mündet, eingeleitet wird, um das flüssige Höhenausgleichsverkleidungsmaterial (6) in dem Umfangsraum (14a) zu vergießen.

12. Verfahren für die Herstellung einer Steuerschnittstelle nach einem der Ansprüche 1 bis 10, **dadurch gekennzeichnet, dass**:
- während eines ersten Schrittes die taktile Platte (2) und das Gehäuse (4) auf einer im Voraus angepassten Oberfläche (17) angeordnet werden, wobei die Öffnung des Gehäuses die Vorderseite (3) der taktilen Platte umgibt, wobei die Öffnung und die Vorderseite gegenüber der im Voraus angepassten Oberfläche (17) angeordnet sind, wobei zwischen die Rückseite (10) der taktilen Platte und einen Haltevorsprung (11) des Gehäuses eine Dichtung (9) eingefügt ist,
- während eines zweiten Schrittes eine Haltekraft (F) auf das Gehäuse ausgeübt wird, um es gegenüber der im Voraus angepassten Oberfläche (17) zu halten und um die Dichtung (9) zwischen die Rückseite (10) der taktilen Platte und dem Haltevorsprung (11) einzuklemmen, und
- während eines dritten Schrittes das flüssige Höhenausgleichsverkleidungsmaterial (6) durch die Einspritzöffnung (12), die von dem Haltevorsprung (11) in einen durch die im Voraus angepasste Oberfläche (17), den Rand (5) und den Haltevorsprung (11) des Gehäuses, die Dichtung (9) und die Schnittfläche (7) der taktilen Platte abgeteilten Umfangsraum (14b) mündet, einzuleiten, um das flüssige Höhenausgleichsverkleidungsmaterial (6) in dem Umfangsraum (14b) zu vergießen, und
- während eines vierten Schrittes ein Film (8), der wenigstens die Vorderseite (3) der taktilen Platte, die Höhenausgleichsverkleidung (6) und die Ränder des Gehäuses (4) abdeckt, aufgebracht wird.

13. Herstellungsverfahren nach einem der Ansprüche 11 oder 12, **dadurch gekennzeichnet, dass** während des zweiten Schrittes die Dichtung (9) mit einem Kompressionsverhältnis im Bereich von 5 % bis 40 % eingeklemmt wird.

## Claims

1. Control interface for a motor vehicle comprising:
- a touch-sensitive tile (2) having a front face (3),
- a casing (4) housing said touch-sensitive tile (2), said casing (4) having an opening delimited by a border (5) so that a user can access the front face (3) of the touch-sensitive tile (2), and
- a levelling compound (6), peripheral to the touch-sensitive tile (2) and interposed between an edge face (7) of the touch-sensitive tile (2) and the border (5) of the casing (4), **characterized in that** said interface also comprises a seal (9) interposed between a rear face (10) of the touch-sensitive tile (2) and a retaining projection (11) of the casing (4), said seal (9) bordering the levelling compound (6) between the rear face (10) of the touch-sensitive tile (2) and the retaining projection (11).

2. Interface according to Claim 1, **characterized in that** said seal (9) comprises a foam.

3. Interface according to Claim 2, **characterized in that** said seal (9) comprises a closed-cell foam.

4. Interface according to Claim 3, **characterized in that** said closed-cell foam is made of polyethylene.

5. Interface according to one of Claims 1 to 4, **characterized in that** said seal (9) comprises an adhesion means.

6. Interface according to one of Claims 1 to 5, **characterized in that** the retaining projection (11) is in the form of a surround extending from the border (5) of the casing (4) toward the centre of the opening.

7. Interface according to one of Claims 1 to 6, **characterized in that** the retaining projection has an interior shoulder.

8. Interface according to one of Claims 1 to 7, **characterized in that** at least one injection orifice (12) and at least one corresponding vent hole (13) are formed in the retaining projection (11) respectively for introducing liquid levelling compound (6) and for discharging air.

9. Interface according to Claim 8 considered in combination with Claim 7, **characterized in that** said injection orifice (12) and said vent hole (13) are positioned on opposite faces of said surround.

10. Interface according to one of the preceding claims, **characterized in that** the casing (4) has at least one strengthening means (16).

11. Method of manufacturing a control interface according to one of Claims 1 to 10, **characterized in that**:
- during a first step, the opening of the casing (4) is positioned around the touch-sensitive tile (2) provided with a film (8) on the front face (3), the film (8) covering at least the front face (3) of the touch-sensitive tile and the edges of the casing, a seal (9) being interposed between the rear face (10) of the touch-sensitive tile and a retaining projection (11) of the casing,
- during a second step, a retaining force (F) is applied to the casing to hold it in position and to compress the seal (9) between the rear face of the touch-sensitive tile and the retaining projection of the casing, and
- during a third step, a liquid levelling compound (6) is introduced via the injection orifice (12) of the retaining projection (11) which orifice opens into a peripheral space (14a) stopped off by the film (8), the border (5) and the retaining projection (11) of the casing, the seal (9) and the edge face (7) of the touch-sensitive tile, so that the liquid levelling compound (6) can be spread out in said peripheral space (14a).

12. Method of manufacturing a control interface according to one of Claims 1 to 10, **characterized in that**:
- during a first step, the touch-sensitive tile (2) and the casing (4) are positioned on a preconfigured surface (17), with the opening of the casing surrounding the front face (3) of the touch-sensitive tile, said opening and said front face being positioned facing the preconfigured surface (17), a seal (9) being interposed between the rear face (10) of the touch-sensitive tile and a retaining projection (11) of the casing,
- during a second step, a retaining force (F) is applied to the casing to hold it in position facing the preconfigured surface (17) and to compress the seal (9) between the rear face (10) of the touch-sensitive tile and the retaining projection (11), and
- during a third step, the liquid levelling compound (6) is introduced via the injection orifice (12) of the retaining projection (11) which orifice opens into a peripheral space (14b) stopped off by the preconfigured surface (17), the border (5) and the retaining projection (11) of the casing, the seal (9) and the edge face (7) of the touch-sensitive tile, so that the liquid levelling compound (6) can be spread out in said peripheral space (14b), and
- during a fourth step, a film (8) is applied that covers at least the front face (3) of the touch-sensitive tile, the levelling compound (6) and the edges of the casing (4).

13. Method of manufacture according to either of Claims 11 and 12, **characterized in that**, during the second step, the seal (9) is compressed with a compression ratio of between 5% and 40%.
